(19) Europäisches Patentamt / European Patent Office / Office européen des brevets

(11) **EP 2 019 490 B1**

(12) **EUROPEAN PATENT SPECIFICATION**

(45) Date of publication and mention
of the grant of the patent:
**18.07.2018 Bulletin 2018/29**

(51) Int Cl.:
***H03M 1/78*** *(2006.01)*   *H03M 1/68* *(2006.01)*
*H03M 1/74* *(2006.01)*

(21) Application number: **07113376.3**

(22) Date of filing: **27.07.2007**

(54) **SEGMENTED CIRCUITRY**

SEGMENTIERTE SCHALTUNG

CIRCUIT SEGMENTÉ

(84) Designated Contracting States:
**DE FR GB**

(43) Date of publication of application:
**28.01.2009 Bulletin 2009/05**

(73) Proprietor: **Socionext Inc.**
**Yokohama-shi, Kanagawa 222-0033 (JP)**

(72) Inventor: **Dedic, Ian Juso**
**Northolt, Middlesex UB5 5HW (GB)**

(74) Representative: **Wilding, Frances Ward**
**Haseltine Lake LLP**
**Lincoln House, 5th Floor**
**300 High Holborn**
**London WC1V 7JH (GB)**

(56) References cited:
**US-A- 5 612 696      US-A- 5 703 586**
**US-A1- 2006 092 065      US-B1- 7 173 552**

**Description**

The present invention relates to segmented circuitry, in particular to segmented mixed-signal circuitry, for example a segmented digital-to-analogue converter (DAC) or a segmented programmable current generator.

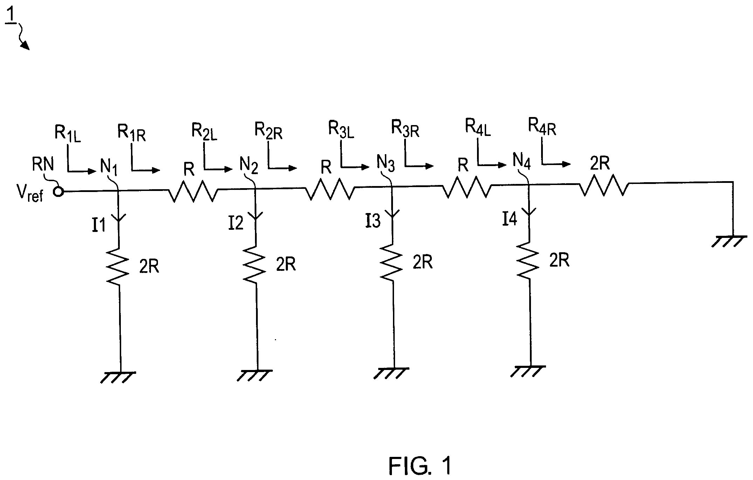

One architecture which has been used to implement a DAC is a so-called R-2R ladder architecture. The basic building block of such an R-2R DAC is an R-2R ladder of the kind shown in Figure 1. In Figure 1, a resistor ladder 1 comprises a series of nodes N1, N2, N3 and N4. Each node is connected to the next node by a divider resistor. These divider resistors are all identical to one another and have a resistance R. The first node N1 is connected to a reference node RN at which a reference voltage $V_{ref}$ is generated. The fourth node N4 is connected to a ground supply line via a terminating resistor which has a resistance of 2R. Each of the nodes N1 to N4 is also connected to the ground supply line by a load resistor which in this case has a resistance value of 2R.

Operation of the resistor ladder 1 can be understood by considering the resistances looking into different parts of the ladder. A resistance $R_{4R}$ looking into the termination resistor at node N4 is simply 2R. A resistance $R_{4L}$ looking into node N4 from the left-hand-side is 2R in parallel with 2R, which is equivalent to a single resistance R. A resistance $R_{3R}$ looking into the divider resistor on the right-hand-side of node N3 is R in series with $R_{4L}$, which is equivalent to a single resistance 2R. A resistance $R_{3L}$ looking into the node N3 from the left-hand-side is 2R in parallel with $R_{3R}$, which is equivalent to a single resistance R. If this analysis is continued all the way through to node N1, it is found that $R_{1R}=R_{2R}=R_{3R}=R_{4R}=2R$. Similarly, it is found that $R_{1L}=R_{2L}=R_{3L}=R_{4L}=R$.

It can be seen that a current I1 flowing between N1 and ground is equal to $V_{ref}/2R$. Because $R_{1R}$ is equal to the resistance of the load resistor connected between N1 and ground, it follows that a current equal to I1 flows into node N2 from N1. At the node N2 this current is split into two equal parts, the first part of which is the current I2 flowing from N2 to ground and the second part of which is the current flowing from N2 into N3. The two parts are equal because $R_{2R}$ is equal to the resistance 2R of the load resistor between N2 and ground. It therefore follows that I2 = $V_{ref}/4R$. The same is true at the nodes N3 and N4 so that I3 = $V_{ref}/8R$ and I4 = $V_{ref}/16R$.

Accordingly, the ladder 1 can achieve binary-weighted currents using relatively few components. Also, the load resistors can be constructed by using two of the divider resistors in series. This should enable a better matching to be achieved between the load resistors and the divider resistors.

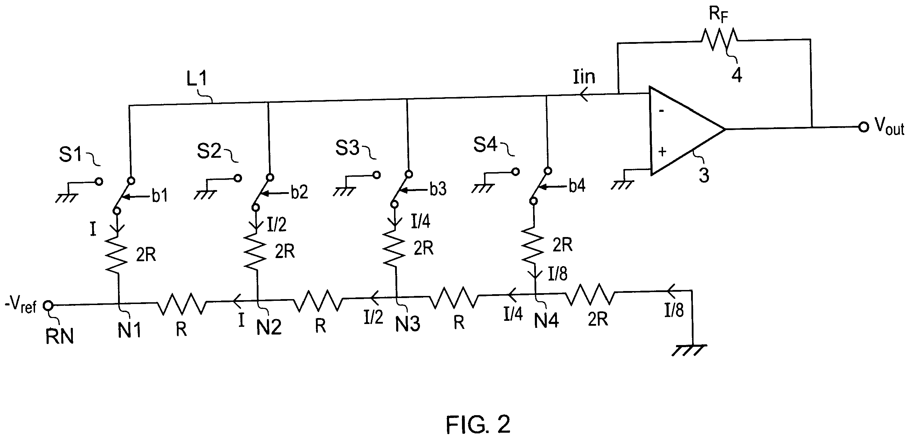

One example of an R-2R DAC using such an R-2R ladder is shown in Figure 2. In this case, the load resistors are connected between the nodes N1 to N4 and respective selection switches S1 to S4, instead of being connected to ground as in Figure 1. Accordingly, depending upon the position of each selection switch S1 to S4, the load resistor is either connected to ground or to a connection line L1. The connection line L1 is also connected to an inverting input of an amplifier 3. As is known in the art, since the operational amplifier 3 has a very high open loop gain, it acts to make the potential difference between its inputs tend to zero. Because the non-inverting input (+) is grounded, the inverting input (-) will assume a similar potential and can therefore be regarded as a "virtual ground". That is, it is maintained at substantially ground potential irrespective of an output $V_{out}$ of the amplifier. Accordingly, respective potentials of the upper ends of the load resistors in the ladder remain at ground potential irrespective of the positions of the selection switches S1 to S4. This means that the ladder arrangement operates in the same way as in Figure 1, and the currents which flow through the load resistors are binary weighted, i.e. I, I/2, I/4 and I/8, where I = $V_{ref}/2R$.

The switches S1 to S4 in Figure 2 correspond respectively to different data bits b1 to b4 of a binary input signal of the DAC. The setting of the switch is by the corresponding data bit. Thus, when b1 = 0, the selection switch S1 connects the load resistor for node N1 to ground. When b1 = 1, the selection switch S1 connects the load resistor for node N1 to the connection line L1. Accordingly, the current I flows from the connection line L1 to the node N1. A current $I_{in}$ flowing into the connection line L1 is therefore changed by I depending on the setting of the switch S1. The same is true for each of the other selection switches S2 to S4.

For example, when all of the data bits b1 to b4 are 1 the selection switches S1 to S4 have the positions shown in Figure 2. In this case $I_{in}$ becomes the sum of the currents flowing through the four load resistors of the ladder arrangement, i.e. I+I/2+I/4+I/8=15I/8. The output voltage $V_{out}$ of the amplifier is $I_{in}.R_F$, where $R_F$ is the resistance of a feedback resistor 4 connected between the non-inverting input of the amplifier 3 and the output thereof. It therefore follows that $V_{out}=V_{ref}.(R_F/2R).[b1+b2/2+b3/4+b4/8]$.

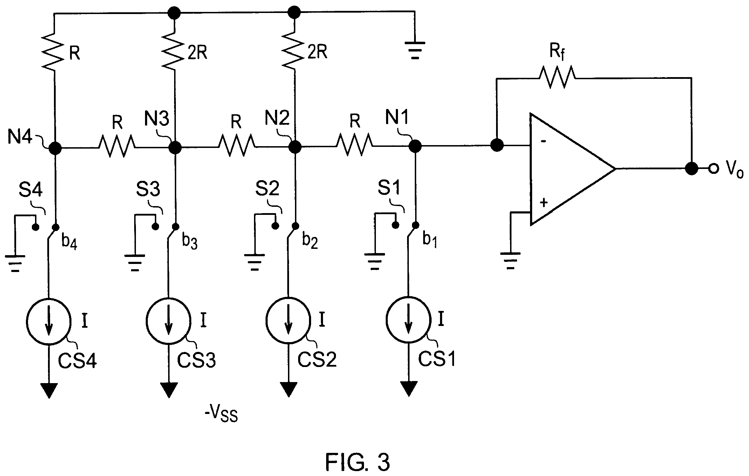

One problem with the DAC of Figure 2 is that, as the number of data bits to be converted increases, the current for the most-significant-bit (MSB) b1 becomes much greater than the current for the least-significant bit (LSB) b4. To avoid this difference, it has also been proposed to implement an R-2R ladder DAC with equal currents through the switches. An example of this approach is shown in Figure 3.

As can be seen in Figure 3, each selection switch S1 to S4 is connected to a negative supply line $-V_{ss}$ via a constant current sink CS1 to CS4. Each current sink CS1 to CS4 causes the same current I to flow through its corresponding selection switch at all times.

It can be seen that each of nodes N4, N3 and N2 sees a resistance R between itself and the upper ground rail, and a resistance R between itself and the next node to the right. For example, node N4 sees a resistance R between itself and the upper ground rail, and a resistance R between itself and node N3. Similarly, node N3 sees a resistance R (2R in parallel with 2R) between itself and the upper ground rail, and a resistance R between itself and node N2. The result is that all of the current drawn by current source CS1 comes from the virtual ground at the inventing input (-) of the operational amplifier, ½ of the current being drawn by current source CS2 comes from that virtual ground, ¼ of the current drawn by current source CS3 comes from that virtual ground, and so on.

Accordingly, it can be seen that DAC circuitry of Figure 3 can achieve binary-weighted currents in a similar way to that of the circuitry in Figures 1 and 2.

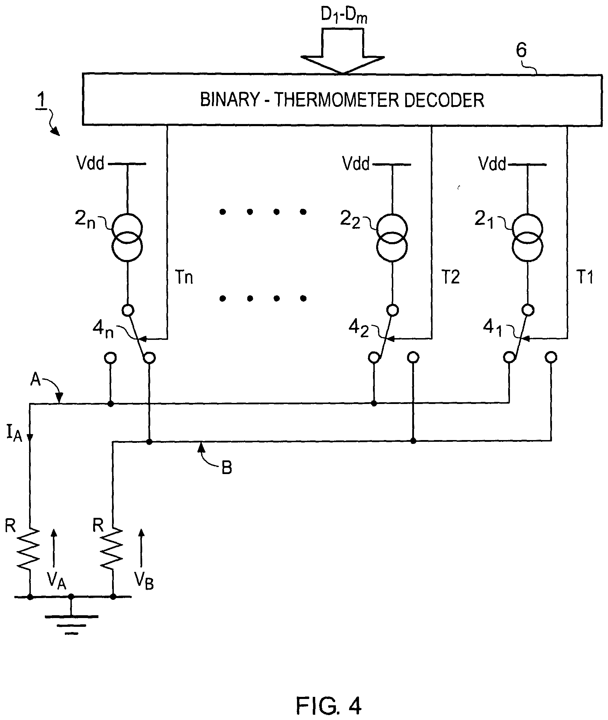

It is also known in DACs to use a so-called segmented architecture. Figure 4 shows an overview of a previously considered segmented DAC. The DAC in Figure 4 is part of a DAC integrated circuit (IC) of the current-steering type, and is designed to convert an m-bit digital input word (D1-Dm) into a corresponding analogue output signal.

Referring to Figure 4, the DAC 1 contains analogue circuitry including a number n of identical current sources $2_1$ to $2_n$, where $n = 2^{m-1}$. Each current source 2 passes a substantially constant current I. The analogue circuitry further includes a number n of differential switching circuits $4_1$ to $4_n$ corresponding respectively to the n current sources $2_1$ to $2_n$. Each differential switching circuit 4 is connected to its corresponding current source 2 and switches the current I produced by the current source either to a first terminal, connected to a first connection line A of the converter, or a second terminal connected to a second connection line B of the converter.

Each differential switching circuit 4 receives one of a plurality of digital control signals T1 to Tn (called "thermometer-coded signals" for reasons explained hereinafter) and selects either its first terminal or its second terminal in accordance with the value of the signal concerned. A first output current $I_A$ of the DAC 1 is the sum of the respective currents delivered to the first terminals of the differential switching circuit, and a second output current $I_B$ of the DAC 1 is the sum of the respective currents delivered to the second terminals of the differential switching circuit. The analogue output signal is the voltage difference $V_A$-$V_B$ between a voltage $V_A$ produced by sinking the first output current $I_A$ of the DAC 1 into a resistance R and a voltage $V_B$ produced by sinking the second output current $I_B$ of the converter into another resistance R.

The thermometer-coded signals T1 to Tn are derived from the binary input word D1-Dm by digital circuitry including a binary-thermometer decoder 6. The decoder 6 operates as follows. When the binary input word D1-Dm has the lowest value the thermometer-coded signals T1-Tn are such that each of the differential switching circuits $4_1$ to $4_n$ selects its second terminal so that all of the current sources $2_1$ to $2_n$ are connected to the second connection line B. In this state, $V_A$=0 and $V_B$=nIR. The analogue output signal $V_A$-$V_B$=-nIR. As the binary input word D1-Dm increases progressively in value, the thermometer-coded signals T1 to Tn produced by the decoder 6 are such that more of the differential switching circuits select their respective first terminals (starting from the differential switching circuit $4_1$) without any differential switching circuit that has already selected its first terminal switching back to its second terminal. When the binary input word D1-Dm has the value i, the first i differential switching circuits $4_1$ to $4_i$ select their respective first terminals, whereas the remaining n-i differential switching circuits $4_{i+1}$ to $4_n$ select their respective second terminals. The analogue output signal $V_A$-$V_B$ is equal to (2i-n)IR.

Thermometer coding is popular in DACs of the current-steering type because, as the binary input word increases, more current sources are switched to the first connection line A without any current source that is already switched to that line A being switched to the other line B. Accordingly, the input/output characteristic of the DAC is monotonic and the glitch impulse resulting from a change of 1 in the input word is small.

In practice, it is not usual to apply the segmented architecture to all bits of the DAC since to do so would require very large numbers of segments. Accordingly, the segmentation is usually applied only to the most significant bits of the DAC, for example the six most significant bits. This requires a total of 63 identical segments. For the remaining bits of the DAC (the least significant bits or LSBs), a non-segmented architecture is typically used. In this case, the currents for the LSBs need to be scaled appropriately relative to the currents in the MSB segments. In other words, the highest LSB will have a current of half each of the MSB segments, second-highest LSB will have a current of one quarter of each of the MSB segments, and so on. One possibility is to use in each LSB circuit circuitry that is basically the same as the circuitry in each MSB segment. The circuitry will typically comprise at least a current source or current sink and a selection switch. Also, depending on the application of the DAC, each MSB segment may also have other components, for example output cascodes, current bleed circuits, and so on. Because the currents flowing in the LSB circuits are scaled down in comparison with the currents flowing in each MSB segment, it follows that it is necessary to scale all of the corresponding components in the LSB circuits. For example, not only must the current source or sink be scaled, but so also must be the selection switch and any associated cascode.

Such scaling of the components in the LSB circuits presents several problems. Firstly, there is a tendency to hit minimum device sizes so full scaling may not be possible for the lower LSBs. Furthermore, the output routing capacitance within the LSB circuits does not scale as compared to the MSB segments. These problems translate into unmatched switching delays for each LSB compared to other LSBs and also compared to the MSB segments. Such unmatched switching delays lead in turn to distortion in the output of the DAC.

The same kind of scaling problems arise even if the LSB circuits are designed differently from the MSB segments. For example, it has been proposed to use a segmented architecture for the MSBs and an R-2R ladder arrangement of the kind shown in Figure 2 for the LSBs. The R-2R ladder arrangement causes the currents for the LSBs to be scaled relative to the currents in the MSB segments. However, even in this case, the LSBs have a different architecture from the MSB segments. Accordingly, it is difficult in practice to match the switching delays for the LSBs compared to each other and compared to the MSB segments.

US 5703586 discloses a Digital-to-Analog (D/A) converter with a programmable transfer function that includes a Main Convertor and at least one Sub-Converter. Errors in the Main Converter are compensated for by programming the one or more Sub-Convertors with compensation values determined during a Calibration Sequence. The Calibration Sequence measures the deviations of the transfer function of the Main Converter from the ideal at predetermined bit transitions of the digital input signal and generates representative separate digital signals for the one or more Sub-Converters. By combining these separate signals with the digital input signal, the net errors of the D/A Converter transfer function are reduced.

US-A1-2006/0092065 discloses a Z/2Z ladder network including an R/2R ladder network having capacitors coupled across series resistors within the R/2R ladder network, wherein the capacitors are sized to substantially match delays from nodes within the ladder network to an output node. The Z/2Z ladder network can be implemented within a digital to analog controller ("DAC"), including higher resolution DACs, and high data rate DACs. In higher resolution DACs, and high data rate DACs, the Z/2Z ladder network is coupled through switches to corresponding current sources. The Z/2Z ladder is optionally implemented differently.

US 7173552 discloses an N-bit segmented digital to analog convertor (DAC) adapted to provide an analog signal output on the basis of a digital input code, the DAC being formed from a plurality of individual segments, the segments being selectively combined to effect the output from the DAC determined by the input, wherein the number of segments is given by $2^N-1+x$ where x is greater or equal to one, and at least one of the segments has a weighting less than that of the least significant bit (LSB) of the overall DAC.

US5612696 discloses a digital-to-analog (D/A) converter of current segmentation. A plurality of current sources are connected in parallel to one another and connected to a load resistance through a plurality of first switches. A second switch is connected in parallel to the first switches and operates oppositely to the first switches. An output impedance compensation resistance is connected in series to the second switch.

According to a first aspect of the present invention, there is provided segmented circuitry as defined in claim 1. Specific embodiments are defined by the dependent claims.

Advantageously, the segments are mutually similar and mutually-similarly-scaled. For example, they may be formed of the same basic circuit elements (e.g. a current source and a load element) connected together in the same basic manner. This means that any mismatches between different segments (for example switching delay mismatches) should be minimised. It will be appreciated that in this way such mismatches can be minimised not only between the first segments, but also between the first segments and the second segments.

Also by having mutually similar and mutually-similarly-scaled segments, the same type of control signal can be used for each segment, and further the magnitude of the controllable signal of each segment can be controllable in the same way in each segment. For example, given the same control signal to each segment, the segments can advantageously be arranged such that the controllable signal has the same magnitude in each cell. Firstly, this is advantageous from a system design point of view; similar circuitry can be repeated per segment throughout the segmented circuitry. Secondly, this leads to improved minimisation of mismatches between the segments. Thirdly, it is advantageous that the controllable signal in the second segments can have the same magnitude as the controllable signal in the first segments (given the same applied control signal), even though the contribution of each second segment to the weighted combination is 1/k of a contribution of each first segment, where k is a scaling factor. Otherwise, it could be imagined that the controllable signal in each second segment would need to have a magnitude 1/k times that of the controllable signal in the first segments (given the same applied control signal), which as k increases could lead to a very small such magnitude in the second segment, which is disadvantageous from a switching-delay mismatch point of view.

The segmented circuitry is further advantageous because the available resolution in the weighted combination of the controllable signals can be increased in a simple manner, by adding an extra stage or stages in the impedance ladder means (i.e. to have one or more third segments, or fourth segments etc). The available resolution can also be changed in a simple manner by varying the number of segments at each such stage, i.e. the number of first segments, second segments, third segments, etc. With these two ways of varying the resolution in the weighted combination of the controllable signals, the design of the segmented circuitry can be optimised from the point of view of the number segments employed, and the number of stages in the impedance ladder means (each such stage having, for example, 1/k of a contribution to the weighted combination of the controllable signals of the contribution of the preceding stage). For example, it is advantageous both to minimise the overall number of segments and to minimise the ratio between the contribution to the weighted combination of the controllable signals made by the first segments and the contribution made by the segment (or segments) in the final stage of the impedance ladder means, i.e. to minimise the number of stages in the impedance ladder means. The segmented of embodiments of the present invention enables this optimisation to be performed whilst maintaining low mismatch between segments.

Preferably, the segmented circuitry is configured such that: the plurality of mutually-similar and mutually-similarly-scaled segments also includes a third segment, the third segment also having such signal changing means operable to change a magnitude of a controllable current of the segment in dependence upon a control signal, and the third segment being connected operatively to a third node of the circuitry; and the impedance ladder means further includes a third load element connected between said third node and said load line and a further divider element connected between said second and third nodes, such that a contribution of said third segment to said weighted combination is 1/k of said contribution of said second segment. Such a third segment forms an extra stage in the impedance ladder means as mentioned above. By having a third such stage, it is possible to increase the available resolution in the weighted combination of the controllable signals to a certain level by employing fewer segments than would be required if that level was obtained with only two such stages.

Preferably, the segmented circuitry is configured such that: said plurality of mutually-similar and mutually-similarly-scaled segments also includes one or more further segments, each said further segment having such signal changing means operable to change a magnitude of a controllable signal of the segment in dependence upon a control signal and each said further segment being connected operatively to a corresponding further node of the circuitry; and said impedance ladder means further includes a further load element connected between each said further node and said load line and also includes a further divider element connected between each said further node and the preceding node. Such further segments form further stages in the impedance ladder means as mentioned above. Again, by having a such further stages, it is possible to increase the available resolution in the weighted combination of the controllable signals to a certain level by employing fewer segments than would be required if that level was obtained with fewer such stages.

Preferably, at least one of the third and subsequent nodes, if any, has two or more such segments connected operatively to the node concerned. By having two or more segments per stage, it is possible to increase the available resolution in the weighted combination of the controllable signals to a certain level by employing fewer such stages than would be required if that level was obtained with one segment per.

Preferably, the segments are arranged in segment groups, each segment group comprising the same number of segments, the segments of each group being connected operatively to the same one of said nodes. It is advantageous to employ such segment groups of the same size from a system design point of view. Similar groups of circuitry can be employed across the segmented circuitry.

Preferably, the number of said segment groups for the first segments is greater than the number of segment groups for said second and any subsequent segments. By having effectively more first segments than segments in other stages of the impedance ladder means, it is possible to achieve a certain level of available resolution in the weighted combination of the controllable signals by having fewer such stages than if the same number of segment groups was employed at each such stage.

An impedance of the or each said divider element may be $(k-1)^2/k$ times an impedance of the or each said load element. A last one of said nodes of the circuitry (i.e. a final such stage) may be connected to the load line by a terminating element. An impedance of the terminating element may be $k-1$ times an impedance of the or each said load element.

Preferably, each said divider element comprises a resistance element and a bridge capacitor connected in parallel with the resistance element. This arrangement can be configured to reduce a variation in the scaling factor k with frequency, particularly at high frequencies, such as from 3 to 6GHz. For example, a capacitance of the bridge capacitor may be at least $k/(k-1)^2$ times a parasitic capacitance of a resistance element in each said load element. A capacitance of the bridge capacitor may preferably be selected so as to compensate for losses at high frequency arising from capacitances (e.g. parasitic capacitances) of, or associated with, the segments.

The or each said divider element and each said load element preferably comprises a plurality of mutually-similar unit resistance elements. By using mutually-similar unit resistance elements, matching between segments and between stages of the impedance ladder means can be advantageously high. Preferably, a number of said unit resistance elements in the or each said divider element is the same as a number of said unit resistance elements in each said load element, the unit resistance elements of the or each said divider element being interconnected differently from the unit resistance elements of each said load element so that the or each said divider element has a different impedance from each said load element. In this way, it can be ensured that the best trade-off between total parasitic capacitance of, and mismatch between, the load elements and divider elements is achieved.

As will be appreciated later herein, in the present invention the relationship between the load elements $Z_L$ and the divider elements $Z_{DIV}$ is preferably $Z_{DIV} = ((k-1)^2/k)Z_L$, where k is a scaling factor. In order to get best matching for a given area of resistance, it is desirable to employ unit resistance elements all having the same resistance R. In order to optimise the matching between two resistance elements (in this case, between the load and divider elements), they should have the same area as one another. Accordingly, the two elements should preferably have the same number of unit resistance elements as one another, interconnected differently as mentioned above to create the required resistance values. The present invention therefore poses a problem as to how to provide the relationship $Z_{DIV} = ((k-1)^2/k)Z_L$ using unit resistance elements.

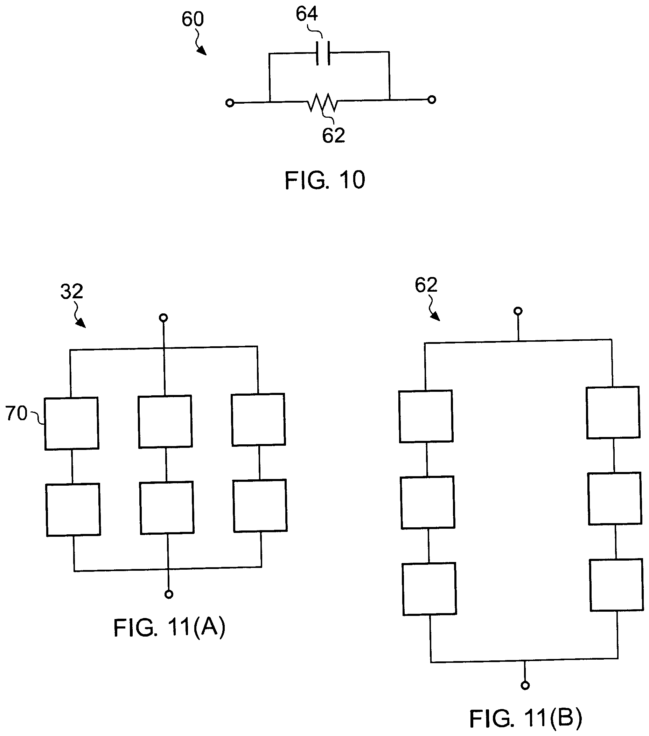

It can be appreciated that it would be possible to interconnect P*Q unit resistance elements (where P and Q are integers) such that, in a first case, there are P parallel branches each having Q elements in series (hereinafter PpQs), and in a second case, there are Q parallel branches each having P elements in series (hereinafter QpPs). In that way, two resistances having a resistance ratio $[P^2/Q^2]:1$ are generated using the same number (P*Q) of unit resistance elements. The required ratio in the present case is of course $[(k-1)^2/k]:1$. Accordingly, it can be seen that scaling factors k, for which k is a perfect square (i.e. $k = Q2$), enable the desired ratio $(k-1)^2/k$ to be achieved by interconnecting P*Q unit resistance elements in the PpQs and QpPs arrangements. That is, values of k of 4, 9, 16, 25, 36, etc are preferable. It will be appreciated that k=4 is preferable from the point of view of minimising the number of such unit resistances required. Figures 11(A) and 11(B) present the two resistor arrangements when k=4.

Preferably, each segment has first and second such controllable signals and said signal changing means in each said segment are operable to change respective magnitudes of said first and second controllable signals of the segment in dependence upon said control signal, and the circuitry has first and second sets of nodes, each said set having such first and subsequent nodes, and the circuitry also has first and second such impedance ladder means, said first impedance ladder means being operable to produce such a weighted combination of the first controllable signals of the plurality of segments and said second impedance ladder means being operable to produce such a weighted combination of the second controllable signals of the plurality of segments. Such segmented circuitry in this way can have differential outputs, an output signal of the circuitry being a difference between the weighted combination of the first controllable signals and the weighted combination of the second controllable signals. Such differential output circuitry is advantageous for the following reasons at least. Firstly, because the output signal of the circuitry is effectively a difference between two signals, small changes in ground potential between such circuitry and a receiver of the output signal do not affect the receiver's ability to detect the signal. Secondly, in systems that employ low supply voltages, problems with signalling can occur because of consequentially-reduced noise immunity. Differential signalling helps to reduce these problems because, for a given supply voltage, it gives twice the noise immunity of a single-ended system. Thirdly, the output signal can be transmitted on balanced lines. A balanced line reduces the noise on a connection by rejecting common-mode interference. Its two wires are routed in parallel so that they receive the same interference. They also have the same impedance to ground, so the interfering fields or currents induce the same voltage in both wires. Since the receiver responds only to the difference between the wires, it is not influenced by the induced noise voltage.

The or each said controllable signal is a current, as indicated in claim 1. In the case of a current, each said segment may comprise a current source or sink connected to a common node of the segment and at least one first switch connected between said common node and a first output node of the segment and at least one second switch connected between said common node and a second output node of the segment.

Preferably, there may be in each segment two or more such first switches and two or more such second switches, and further means for controlling the first and second switches such that at each switching event the same number of switches change state. Each such segment may further comprise means for reducing an output impedance at each said output node.

It will be appreciated that such segmented circuitry could form a digital-to analogue converter (DAC) or a segmented programmable current generator.

According to an embodiment of a second aspect of the present invention, there is provided a digital-to-analogue converter (DAC) comprising segmented circuitry according to the aforementioned first aspect of the present invention, wherein the digital input signal is an input signal of the converter. Such a DAC may operate at a sample rate of around 12GSa/s.

According to an embodiment of a third aspect of the present invention, there is provided a segmented programmable current generator comprising segmented circuitry according to the aforementioned first aspect of the present invention, wherein the digital input signal is an input signal of the generator.

It is envisaged that the present invention may extend to further such aspects. Circuitry embodying the present invention may be provided in the form of an integrated circuit (IC) chip or chipset. According to an embodiment of a further aspect of the present invention there is provided an IC chip or chipset comprising circuitry according to any of the above-mentioned aspects of the present invention. Such an IC chip or chipset may be a small-geometry CMOS IC chip or chipset. Circuitry embodying the present invention may form part of an RF transmitter, for example part of a DAC of an RF transmitter. According to an embodiment of a further aspect of the present invention there is provided an RF transmitter comprising circuitry or an IC chip or chipset (as the case may be) according to any of the above-mentioned aspects of the present invention.

Reference will now be made, by way of example, to the accompanying drawings, in which:

Figure 1 shows a circuit diagram of an R-2R ladder;
Figure 2 shows a first example of a DAC employing an R-2R ladder architecture;
Figure 3 shows a second example of a DAC employing an R-2R ladder architecture;
Figure 4 shows an example of a DAC employing a segmented architecture;
Figure 5 shows parts of a DAC not directly embodying the present invention but useful for understanding embodiments thereof;
Figure 6 shows parts of a DAC embodying the present invention;
Figure 7 shows parts of the Figure 6 DAC in more detail;
Figure 8 shows parts of a DAC according to a first embodiment of the present invention;
Figure 9 shows an overall connection arrangement of the Figure 8 parts;
Figure 10 shows a possible implementation of a divider element in the Figure 8 DAC;
Figures 11(A) and 11(B) show possible implementations of resistance elements in the Figure 8 DAC; and
Figure 12 shows parts of a DAC according to a second embodiment of the present invention.

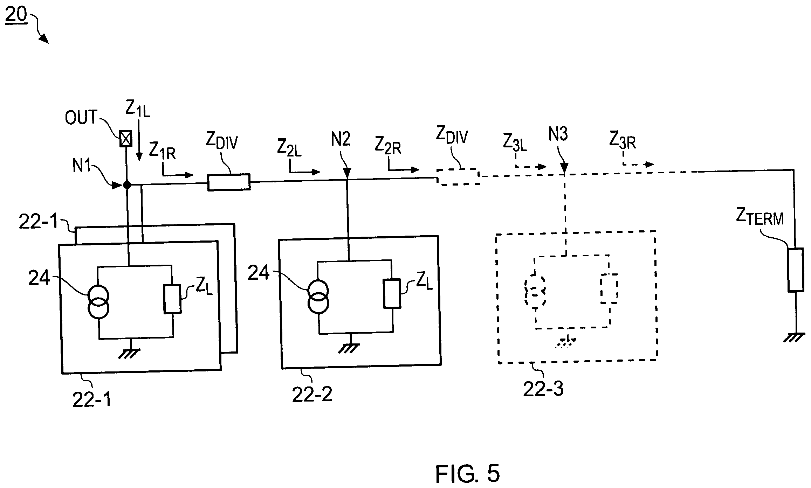

Figure 5 shows parts of segmented mixed-signal circuitry 20 not directly embodying the present invention, but useful for understanding embodiments thereof. The circuitry 20 is, for example, part of a DAC.

The circuitry 20 comprises a plurality of mutually-similar and mutually-similarly-scaled circuitry segments 22. The circuitry segments comprise at least two first segments 22-1 which are connected to a first node N1 of the circuitry. The circuitry further comprises a second segment 22-2 connected to a second node N2 of the circuitry. In addition to the plural first segments 22-1 and the second segment 22-2 it is also possible to provide further segments. For example, as shown in the dotted lines in Figure 5, a third segment 22-3 can be connected to a third node N3.

Each of the circuitry segments 22 can be constituted in many different ways and what is shown in each segment in Figure 5 is merely an equivalent circuit of a segment. This equivalent circuit comprises a current source 24 connected in parallel with a load impedance $Z_L$.

The first node N1 is connected to the second node N2 by a divider element having an impedance $Z_{DIV}$. Similarly, the node N2 is connected to the node N3 via a divider element having the same impedance $Z_{DIV}$. The last of the nodes in the circuitry is connected to ground via a termination element having a termination impedance $Z_{TERM}$.

The first node N1 is connected to an output node OUT of the DAC.

In general, in the present invention the relationship between the load impedance $Z_L$, the divider impedance $Z_{DIV}$ and the termination impedance $Z_{TERM}$ is as follows:

$$Z_{DIV} = ((k-1)^2/k)Z_L$$

$$Z_{TERM} = (k-1)Z_L$$

where k is a scaling factor.

In the minimum case shown in Figure 5, where there is only one segment connected to each of the second and subsequent nodes N2, N3 etc, the scaling factor k should be set to 2. In this case, $Z_{DIV} = \frac{1}{2} Z_L$ and $Z_{TERM} = Z_L$. It will be observed that these are the same impedance ratios as in the Figure 1 circuitry described in the introduction.

When the impedances are set in the manner described above, the impedance looking from the right-hand-side of each of the nodes N1, N2 and N3 into the divider element (or termination element) is $(k-1)Z_L$, i.e. $Z_L$ when k = 2. Thus, $Z_{1R}$, $Z_{2R}$ and $Z_{3R}$ in Figure 5 are each $Z_L$ when k=2.

Also, the impedances looking into each of the nodes N2, N3 etc (but not N1 as noted below) from the left-hand-side are $((k-1)/k)Z_L$. In the case in which k=2, these impedances are $\frac{1}{2} Z_L$. Thus, $Z_{2L}$, $Z_{3L}$ etc in Figure 5 are $\frac{1}{2} Z_L$ when k=2.

Because there are plural first segments 22-1 connected to the first node N1, the impedance $Z_{1L}$ looking into the node N1 from the output node OUT is not the same as $Z_{2L}$ or $Z_{3L}$. The impedance $Z_{1L}$ is the parallel combination of the load impedances $Z_L$ in the first segments and $Z_{1R}$. Thus, $Z_{1L}=(k-1)/(i+k-1)$, where i is the number of first segments 22-1.

In the Figure 5 circuitry, the output signal at the output terminal OUT is a weighted combination of the respective signals produced by the individual segments. In the weighted combination, the contribution of the second segment 22-2 is 1/k of the contribution of each first segment 22-1. Similarly, the contribution of the third segment 22-3 is 1/k of the contribution of the second segment.

Each first segment produces its segment signals in dependence upon two or more first bits of the digital input signal applied to the DAC. The second segment produces its segment signal in dependence upon a further bit of a digital input signal. This further bit is the next less significant bit after the least significant bit among the first bits. The third segment produces its segment signal in dependence upon the next bit after the further bit.

An advantage of the Figure 5 circuitry is that each of the segments has the same basic elements (the current source 24 and load element ZL). This means that the mismatches between different segments should be minimised. For example, the mismatch in switching delays between the different segments 22-2 and 22-3 should be reduced. Also, the mismatch between the switching delays of each of these LSB segments and each of the MSB segments 22-1 should also be reduced.

Another advantage is that adding extra resolution to the DAC becomes relatively easy, since all that is necessary is to provide extra stages in the ladder arrangement, rather than scaling the components.

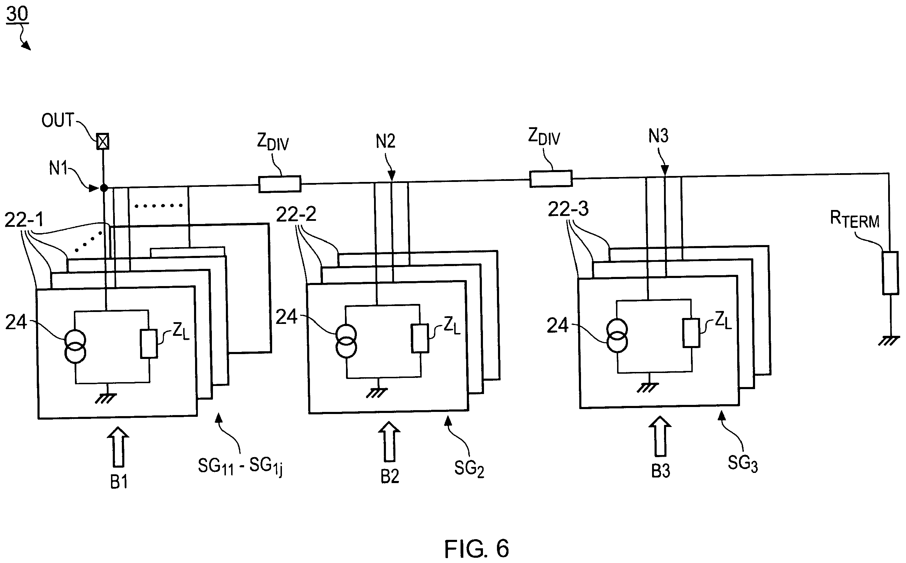

Figure 6 shows an example of parts of DAC circuitry embodying the present invention. The Figure 6 circuitry 30 differs from the Figure 5 circuitry 20 in that at least three first segments 22-1 are connected to the first node N1, at least three second segments 22-2 are connected to the second node N2 and three third segments 22-3 are connected to the third node N3. The second segments 22-2 together constitute a segment group $SG_2$ for the node N2. Similarly, the third segments 22-3 together constitute a segment group $SG_3$ for the third node N3.

Because there is a group of segments in each of the segment groups $SG_2$ and $SG_3$, these segment groups can be used to process more than one bit of the digital input signal. For example, each of the segment groups $SG_2$ and $SG_3$ may be used to process two or three bits of the digital input signal. Thus, the segment group $SG_3$ is shown as receiving plural bits B3 of the digital input signal, and the segment group $SG_2$ is shown as receiving plural bits B2 of the binary input signal.

Of course, in practice, the bits of the digital input signal will not normally be applied directly to the segments. Typically, the bits will be decoded by a suitable decoder, such as a binary-to-thermometer decoder (as described previously with reference to Figure 4). The decoder generates thermometer-coded signals for each segment based on the relevant bits of the digital input signal. When thermometer coding is used, and the number of binary bits is 2, the number of segments in each segment group $SG_2$ and $SG_3$ should be 3. When the number of binary bits is 3, the number of segments in the segment groups should be 7. Incidentally, the number of segments required is $2^n-1$, rather than $2^n$, because for one of the binary input values (e.g. all zeros) no segment signal is required. In practice, more than the minimum number of segments may be provided, for example so that a segment can be isolated from the remaining parts of the circuitry for calibration purposes whilst still leaving the required minimum number available for processing the digital input signal. Also, as explained later, it is desirable for each segment group to have the same number of segments. This may also make it desirable to include more segments in each group, e.g. $2^n$ segments, even if no spare "calibration" segment is required.

In the Figure 6 circuitry, the scaling factor k is increased because plural segments are attached to each of the nodes N2 and N3. For example, if the number of bits in each of B2 and B3 is 2, then k should be set to 4 so that the outputs of the second segments 22-2 are scaled by a factor of 4 relative to the outputs of the first segments 22-1 and so that the outputs of the third segments 22-3 are scaled by a factor of 16 relative to the outputs of the first segments 22-1.

In Figure 6, at least three first segments 22-1 are connected to the first node N1. In this case, however, the number of first segments is greater than the number of segments in the segment group $SG_2$ and in the segment group $SG_3$. This is not essential, and the number of first segments 22-1 could be equal to the number of segments in the segment groups $SG_2$ and $SG_3$. For reasons that will be explained later, it is preferable to organise the first segments 22-1 as plural segment groups $SG_{11}$ to $SG_{1j}$. Each of the segment groups $SG_{11}$ to $SG_{1j}$ has the same number of segments as each of the segment groups $SG_2$ and $SG_3$. For example, the number of segments in each segment group may be four.

To give a concrete example, the case of a ten-bit DAC will be considered. In this case, the six MSBs are processed by the first segments 22-1. In this case, 64 first segments are provided (63 working segments and 1 segment for calibration). These 64 segments are organised as 16 segment groups $SG_{11}$ to $SG_{116}$.

The two highest-order LSBs (the bits B2 in Figure 6) are processed by the second segments 22-2 in the segment group $SG_2$. Four segments are provided in the group $SG_2$ (3 working segments and 1 for calibration). Similarly, the two lowest-order LSBs (the bits B3 in Figure 6) are processed by the third segments 22-3 in the segment group $SG_3$. Again, four segments are provided in the segment group $SG_3$ (3 working segments and 1 for calibration).

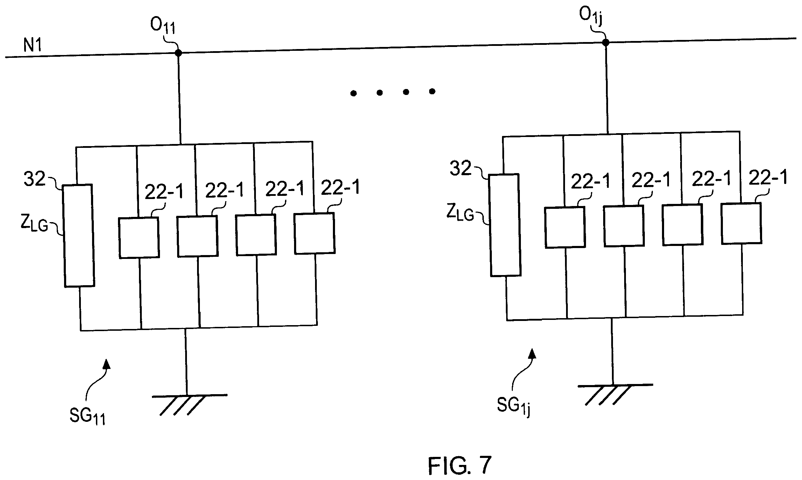

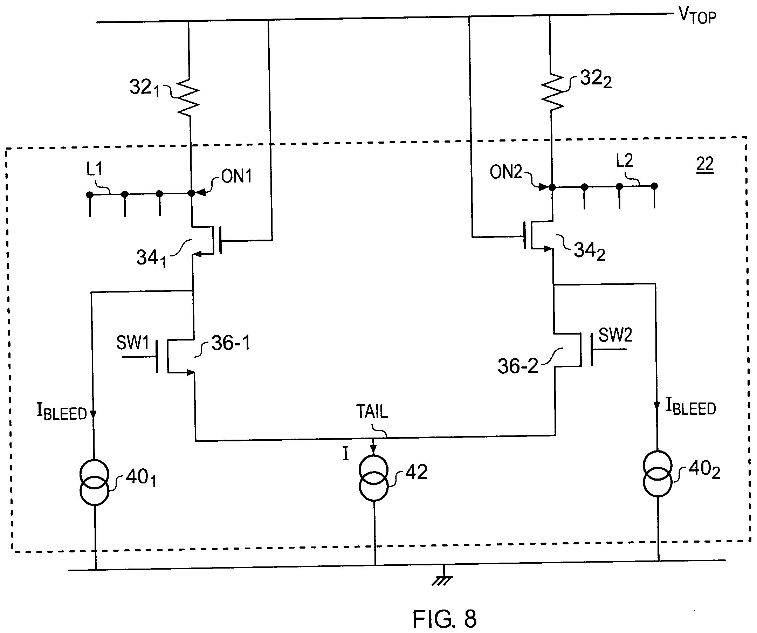

It can be seen that in Figure 6, the segments in each segment group SG have their respective load impedances $Z_L$ connected in parallel between the relevant node N1/N2/N3 and ground. Because of this, it is possible for a segment group SG to share a load element having a load impedance $Z_{LG}$. Figure 7 shows the first segment groups $SG_{11}$ to $SG_{1j}$ connected to node N1. Four first segments 22-1 (now not having loads $Z_L$ of their own) are connected in parallel between an output node $O_{11}$ of the segment group $SG_{11}$ and ground. A shared load element 32 is also connected between the output node $O_{11}$ for the segment group and ground. The same is true for each of the other first segment groups $SG_{11}$ to $SG_{1j}$. For the first segment groups $SG_{11}$ to $SG_{1j}$, the corresponding output nodes $O_{11}$ to $O_{1j}$ are of course connected together to form node N1. The segment group $SG_2$ can also have a shared load element 32 connected in parallel with the segments of its group. Similarly, the segment group $SG_3$ can also have a shared load element 32 connected in parallel with the segments of its group. It will be appreciated that although shared load elements $Z_{LG}$ 32 are shown in Figure 7 connected between the output nodes for the segment group concerned and ground, they could equivalently be shown connected instead between an upper reference supply $V_{TOP}$ and their respective output nodes, as will be appreciated in respect of Figure 8.

The impedance $Z_{LG}$ required of each shared load element is $((k-1)^2/k)Z_{LG}$. Similarly, $Z_{TERM} = (k-1)Z_{LG}$ in this case.

It may be preferable to provide a shared load element for each segment group because, depending on the particular process (technology) used to fabricate the chip, a shared load element (having a smaller impedance than a per-segment load element) may be easier to fabricate. In particular, a per-segment load element may need to have a relatively large impedance (resistance), which will have an undesirably large area and hence a large parasitic capacitance. However, the use of per-segment load elements in the Figure 6 circuit is still possible, and may be preferable in certain fabrication processes.

Figure 8 shows an example constitution of one of the segments 22 in a first embodiment of the present invention. In this embodiment, the DAC is a differential DAC and has first and second output nodes. Each of these output nodes effectively corresponds to the output node OUT shown in Figure 5 and Figure 6.

Each segment comprises first and second main switching transistors 36-1 and 36-2. The respective sources of the main switching transistors 36-1 and 36-2 are connected to a common node TAIL of the segment. A current sink 42 is connected between the common node TAIL and ground. This current sink causes a constant current I to flow through the node TAIL in use of the DAC. Mutually-complementary drive signals SW1 and SW2 are applied to the gates of the main switching transistors 36-1 and 36-2.

The drain of the first main switching transistor 36-1 is connected to the source of a first cascode transistor $34_1$. The drain of the second main switching transistor 26-2 is connected to the source of a second cascode transistor $34_2$. A gate of the first cascode transistor $34_1$ is connected to a positive supply line $V_{TOP}$ of the DAC. The second cascode transistor $34_2$ has its drain connected to a second output node ON2 of the segment and its gate connected to the supply line $V_{TOP}$. A first bleed current sink $40_1$ is connected to the source of the first cascode transistor $34_1$ and a second bleed current sink $40_2$ is connected to the source of the second cascode transistor $34_2$.

The respective first output nodes ON1 of the segments within the same segment group SG are connected together by a first line L1. The line L1 is also connected to the positive supply line $V_{TOP}$ by a first shared load element $32_1$. Similarly, the respective second nodes ON2 of the segments within the same segment group are connected together by a second line L2. The line L2 is also connected to the positive supply line $V_{TOP}$ by a second shared load element $32_2$. Each of the first and second shared load elements $32_1$ and $32_2$ corresponds to the shared load element 32 shown in Figure 7. Each shared load element $32_1$ and $32_2$ has an impedance $Z_{LG}$. As indicated previously $Z_{DIV} = ((k-1)^2/k)Z_{LG}$.

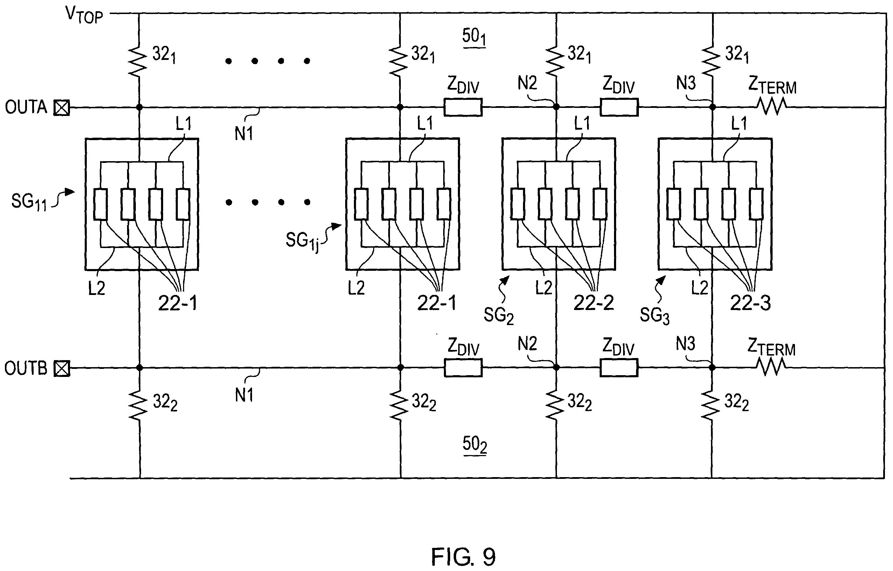

Figure 9 shows how the different segment groups are interconnected in the first embodiment. The first shared load elements $32_1$ form part of a first impedance ladder arrangement $50_1$. This first ladder arrangement has nodes N1, N2 and N3 as described previously. The first and second nodes N1 and N2 are interconnected by a divider element having impedance $Z_{DIV}$. Similarly, the second and third nodes N2 and N3 are connected together by a divider element having the impedance $Z_{DIV}$. The third node N3 is connected to the positive supply line $V_{TOP}$ by a termination element having the impedance $Z_{TERM}$. The respective first lines L1 of each of the first segment groups $SG_{11}$ to $SG_{1j}$ are connected in common to the first node N1 of the first ladder arrangement $50_1$. The line L1 of the second segment group $SG_2$ is connected to the second node N2 of the ladder arrangement $50_1$. The line L1 of the third segment group $SG_3$ is connected to the third node N3 of the first ladder arrangement $50_1$. The first shared load elements $32_1$ of all the segment groups therefore form part of the first ladder arrangement $50_1$.

The Figure 9 DAC also comprises a second impedance ladder arrangement $50_2$. This second ladder arrangement comprises the respective second shared load elements $32_2$ of all of the segment groups. This second ladder arrangement $50_2$ has first, second and third nodes N1, N2 and N3 similar to the first ladder arrangement $50_1$. The respective second lines L2 of the first segment groups $SG_{11}$ to $SG_{1j}$ are connected in common to the first node N1 of the second ladder arrangement $50_2$, the second line L2 of the second segment group $SG_2$ is connected to the node N2 of the second ladder arrangement $50_2$, and the second line L2 of the third segment group $SG_3$ is connected to the third node N3 of the second ladder arrangement $50_2$. The second ladder arrangement $50_2$ also has the divider elements and termination element just as in the first ladder arrangement $50_1$.

It is emphasised that Figure 9 is schematic in nature, the two impedance ladder arrangements $50_1$ and $50_2$ being shown above and below the segments merely so that their equivalence to one another can be clearly seen. For example, ground connections of the segments are not shown in Figure 9, and accordingly the representation of the segments in Figure 9 differs from that in, for example, Figure 7. Effectively, Figure 9 is intended to show the two sets of signal paths of the impedance ladder arrangements.

Operation of the embodiment of Figures 8 and 9 will now be described. Each segment 22 receives a corresponding pair of mutually-complementary drive signals SW1 and SW2 from a binary-to-thermometer decoder (not shown). According to the states of the complementary drive signals SW1 and SW2, one of the main switching transistors 36-1 and 36-2 in each segment is turned ON and the other of those two transistors is turned OFF. Accordingly, the current I flows either through the transistor 36-1 or the transistor 36-2. Each of the cascode transistors $34_1$ and $34_2$ is maintained permanently on and in the saturated condition because the gate of each cascode transistor is connected to $V_{TOP}$. The bleed current sinks $40_1$ and $40_2$ ensure that sufficient current flow is maintained through each of the cascode transistors even when the transistor 36-1 or 36-2 to which it is connected is turned off. For example $I_{BLEED}$ may be around one quarter of I.

Accordingly, at any given time, $I_{BLEED}+I$ is drawn into the segment from one of the two output nodes ON1 and ON2 and $I_{BLEED}$ is drawn from the other output node. The output node which has $I+I_{BLEED}$ is determined by the switching state of the segment concerned. The current drawn into the segment through the first output node ON1 is a first controllable signal of the segment. The current drawn into the segment through the second output node ON2 is a second controllable signal of the segment. The magnitudes of the first and second controllable signals are controlled by the switching signals SW1 and SW2 applied to the segment.

Because the first output nodes of the segments within a segment group are connected together by the line L1, the currents drawn through the first output nodes are summed. Similarly, the currents drawn through the second output nodes of the segments within the segment group are also summed because of the interconnection of those nodes by the line L2. The effect of the first impedance ladder network $50_1$ is to scale the contribution of each second segment 22-2 in the second segment group $SG_2$ by the scaling factor k in relation to that of each first segment 22-1 in any of the first segment groups $SG_{11}$ to $SG_{1j}$. Similarly, the contribution to the output voltage at the output terminal OUTA of each third segment 22-3 in the segment group $SG_3$ is scaled by the factor $k^2$ as compared to the contribution of each first segment.

Figure 10 shows an example of the implementation of each of the $Z_{DIV}$ in the present invention. As shown in Figure 10, each divider element comprises a resistance element 62 and a bridge capacitor 64 connected in parallel with the resistance element 62. The capacitor 64 is used to compensate for the capacitance associated with the load elements ($32_1$ and $32_2$). Because $Z_{DIV} = ((k-1)^2/k)Z_{LG}$, the capacitance of the bridge capacitor should be at least $k/(k-1)^2$ times the capacitance of each load element $32_1$ or $32_2$. This ensures that, not only do the impedances of the divider elements have the appropriate ratio to the impedances of the load elements at DC but they also have the appropriate ratio at high frequencies as well. In other words, the scaling factor k is constant across all frequencies.

It is also possible to trim the capacitors 64 (increasing them slightly) to compensate for any parasitic capacitances associated with the resistors. These resistor parasitic capacitances cause losses at high frequencies of signals propagating along the series of nodes N1 to N3 in each impedance ladder arrangement in the direction to the output terminal. Provided that the parasitic capacitances are moderate, the effect of the losses can be compensated for by increasing the capacitance of the bridge capacitor slightly. Thus, the capacitance $C_{64}$ of the bridge capacitance should be $(k_{cdiv}.k)/(k-1)^2$ times the capacitance of each load element $32_1$ or $32_2$, where $k_{cdiv}$ is a compensation factor. If $k_{cdiv} = 1$, the bridge capacitance $C_{64}$ is simply the same as the capacitance needed to match the impedance of the load elements, i.e. $k/(k-1)^2$ times the capacitance of the load elements. The compensation factor is dependent on many factors, including the fabrication process and design choices such as segment design (e.g. the capacitance of the current source and output switches in each segment) and ESD protection arrangements. Example values are given later.

In embodiments of the present invention, it is important for the load elements, divider elements and termination elements to have matching impedances (resistances). Figures 11(A) and 11(B) show a preferred way of achieving such matching. In this example, it is assumed that the scaling factor k is 4. In this case, it is required that $Z_{DIV} = (9/4).Z_{LG}$. In this example, it will be assumed that the number of first segment groups is 16 and that a target output impedance of the DAC is 25Ω. In this case, because 16 shared load elements $32_1$ are connected to the output terminal OUTA and 16 shared load elements $32_2$ are connected to the second output terminal OUTB, it follows that $Z_{LG}$ should be 16 x 25 = 400Ω. At any one time, only 63 of the 64 MSB segments are in use (the 64th being calibrated), and the LSB segments collectively serve as a 64th segment. The MSB segments together contribute, in the present example, 63/64 of the output range, and the LSB segments together contribute 1/64 of the output range. It follows that $Z_{DIV}$ should be 900Ω.

In this case, the resistance element 62 in each divider element 60 can be implemented using 6 unit resistances 70, each having a resistance R of 600Ω. The resistance element 62 in Figure 11(A) has three parallel branches. Each branch has two unit resistances 70 connected in series. The resulting overall resistance is 400Ω.

Similarly, the resistance element in each divider element 60 can be implemented as shown in Figure 11(B). In this case, the resistance element 62 has two parallel branches, each branch having three of the unit resistances 70 connected in series The resulting impedance is 900Ω.

Because the unit resistances 70 in the load elements and divider elements are the same, accurate matching of the resistance values of the load elements and divider elements is obtainable. This is possible because the unit resistances have the same width and length, thereby eliminating width and length effects.

The following explanation relates to one possible process (technology) only and explains how the resistances and bridge capacitors can be implemented in this particular process.

For example, it is envisaged that the unit resistances might be implemented in the chosen process using non-silicided polysilicon. Non-silicided polysilicon has a resistance of 450Ω/~. The maximum current permitted in such a resistor is 0.28mA/$\mu$m. It is assumed that each first segment group $SG_{11}$ to $SG_{lj}$ is capable of causing a maximum current of 1.25mA to flow through the node N1 (this corresponds to a full scale output current of 16 x 1.25mA = 20mA). This means that the load elements $32_1$ and $32_2$ connected to the nodes N1 in the ladder arrangements $50_1$ and $50_2$ must each be capable of handling a current of 1.25mA. As shown in Figure 11(A), each of the load elements 32 is constituted by 3 parallel branches. The maximum current in each branch is 1.25mA/3 = 0.42mA. This means that the minimum width of each of the unit resistances 70 is 1.48$\mu$m. Because each unit resistance 70 is required to have a resistance of 600Ω, in non-silicided polysilicon this corresponds to 1.33 ~. This corresponds to a minimum length of 1.33 x 1.48 = 1.98 $\mu$m. The area of each unit resistance is then 3 $\mu$m$^2$. The total area occupied by each of the resistors 32 and 62 is 3 $\mu$m x 6 = 18 $\mu$m$^2$. In practice, the chosen process may have its own minimum width and length requirements for resistance elements unrelated to current handling considerations. In the present example, it is assumed that $W_{min}$ = 1.5 $\mu$m and $L_{min}$ = 2 $\mu$m. It is therefore chosen to make each unit resistance have a width W of 1.5 $\mu$m and a length of 2 $\mu$m.

One of the constraints in designing circuitry embodying the present invention is the accuracy of the resistors. Generally, the mismatch between resistors is inversely proportional to the square root of the area of the resistor. For example, for non-silicided polysilicon resistors the mismatch (standard deviation $\sigma$) may be 1.33%/$\sqrt{A}$, where A is the resistor area. If A = 18 $\mu$m$^2$, then $\sigma$ = 0.31%. Taking a practical example in which the DAC has 12 bits, with 6 MSBs (B1 in Figure 6) and 6 LSBs (B2 + B3 in Figure 6), the required accuracy is 100%/64 = 1.6%, which is around 5$\sigma$. Typically, a 3$\sigma$ figure can be used, i.e. 0.9%, which is around ½ an LSB. Effectively, this means that 13-bit accuracy (linearity) can be expected. Incidentally, in principle it is possible to calibrate out the effects of resistor mismatches, e.g. by adjusting the currents produced by the current sources in individual segments. However, it appears that this is not necessary in practice, because the expected accuracies exceed the presently-contemplated numbers of bits.

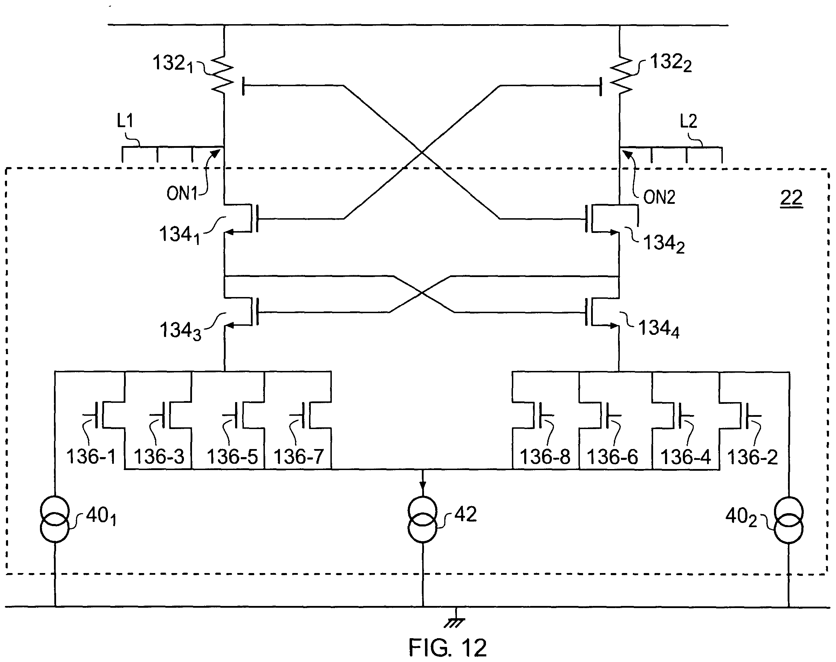

The larger the resistors, the larger their parasitic capacitances. However, it appears that in practice the parasitic capacitances of the resistors are less than half the parasitic capacitances of the output transistors (134-1 and 134-2) in the segments (see Figure 12).

As already mentioned in respect of Figure 10, each divider impedance $Z_{DIV}$ is implemented as a resistor in parallel with a bridge capacitor such that the scaling factor k is constant across all frequencies. Also as already mentioned, it is possible to apply a compensation factor $k_{cdiv}$ to the value of the bridge capacitances in order to compensate for parasitic capacitances. In order to explore this further, the following analysis has been carried out.

For this analysis, it is assumed that the target output resistance of the DAC is 25Ω, and allowance is made in the DAC output capacitance of 0.2pF for ESD circuitry, 0.2pF for the DAC transistors, and 0.2pF for the tracking in the DAC.

Accordingly, taking into account the parasitic capacitance for the DAC transistors and the tracking, amounting to 0.4pF, and given 16 segment groups in the DAC, this amounts to 25fF (0.4pF/16) output capacitance for each segment group.

Considering just the output capacitance due to the tracking and DAC transistors, calculations show that the loss experienced is around -0.24dB at 6GHz (which, given a 12 GSa/s DAC, is the highest frequency of concern). Considering just the output capacitance due to the resistances, calculations show that the loss experienced is around -0.18dB at 6GHz. Considering the output capacitance due to the tracking, DAC transistors and the resistances, calculations show that the loss experienced is around □ 0.4dB at 6GHz. This is an error of 4%, which equates to 12-bit accuracy with about 2.5 LSBs error. This is much larger than the desirable <1 LSB error at 12-bit accuracy.

If the bridge capacitors of $Z_{DIV}$ are set using compensation $k_{cdiv}$ = 1 (i.e. no compensation), calculations show that the loss experienced as a result of the output capacitance due to the tracking and DAC transistors alone reduces to around 0dB at 6GHz. However, with $k_{cdiv}$ = 1, calculations show that the loss experienced as a result of the output capacitance due to the tracking, DAC transistors and the resistances is only reduced to around 0.16dB at 6GHz.

Further calculations show that by adjusting the applied compensation to $k_{cdiv}$ = 1.44, the loss experienced due to the output capacitance as a result of the tracking, DAC transistors and the resistances becomes negligible, i.e. reduces to around 0dB at 6GHz. With k = 4 and the resistance $Z_{DIV}$ being 900 Ω as before, this equates to the bridge capacitance in $Z_{DIV}$ being around 16fF (25fF x ($^4/_9$) x 1.44). In this situation, with the resistance of $Z_{TERM}$ being 1200Ω as before, this equates to the bridge capacitance in $Z_{TERM}$ being 12fF (16fF x (¾)).

Consideration has also been given to the effect of variation in capacitances due to inaccuracies in the processes employed in the manufacture of the DAC. The bridge capacitors could be formed out of metal, in which case variation in capacitance of the bridge capacitances will match variation in parasitic capacitance due to the tracking. Because the contribution of the tracking (0.2pF) to the output capacitance is assumed to be equal to the contribution due to the DAC transistors (0.2pF), a 20% variation in the parasitic capacitance of the DAC transistors relative to the metal capacitances equates to an overall effective 10% error in the value of the bridge capacitances. With 10% error in the value of the bridge capacitances, calculations show that the error in the loss experienced due to the combination of the output capacitance $C_{OUT}$ in respect of the tracking and DAC transistors together with the resistances is around ±0.12dB at 6GHz, which equates to 12-bit accuracy with about 0.75 LSB error (i.e. less than 1 part in 64). Further calculations show that the error is around ±0.05dB at 3GHz, which equates to 12-bit accuracy with about 0.3 LSB error, i.e. the DAC will have almost ideal performance to 14-bit accuracy at 3GHz (which is a high enough frequency, for example, for outputting RF signals).

Overall, considering the target output resistance of 25Ω and the allowed output capacitance of 0.6pF (0.2pF for DAC transistors, 0.2pF for tracking, and 0.2pF for ESD circuitry), calculations show that the DAC can have an output bandwidth of -3dB at 20GHz.

Figure 12 shows parts of each of the segments 22 in a second embodiment of the present invention. Parts in Figure 12 that are the same as the parts in the first embodiment (Figure 8) are denoted by the same reference numerals. In Figure 12, a plurality of main switching transistors are provided for each output node ON1 and ON2 of the segment. Transistors 136-1, 136-3, 136-5 and 136-7 are provided for the first output node ON1. Transistors 136-2, 136-4, 136-6 and 136-8 are provided for the second output node ON2. Also, the arrangement of cascode transistors is changed in comparison to the Figure 8 segment. There are now two cascode transistors per output node. The cascode transistors $134_1$ and $134_3$ are provided for the first output node ON1, and the cascode transistors $134_2$ and $134_4$ are provided for the second output node ON2. The upper cascode transistors $134_1$ and $134_2$ are provided to eliminate the dependence of the drain potentials of the switching transistors 136 on the potentials of the output nodes ON1 and ON2. This is achieved by taking a tap from a tap point TP1 or TP2 on each of the first and second shared load elements $132_1$ and $132_2$. The tap point TP1 from the first shared load element $132_1$ is coupled to a gate of the cascode transistor $134_2$. The tap point TP2 from the second shared load element $132_2$ is coupled to a gate of the cascode transistor $134_1$. The potential at the tap point TP1 is a scaled-down version of the potential at the first output node ON1. Similarly, the potential at the tap point TP2 is a scaled-down version of the potential at the second output node ON2. Application of the scaled-down potentials to the gates of the cascode transistors $134_1$ and $134_2$ therefore serves to fix their source potentials at values that are substantially independent of the output-node potentials. The further pair of cascode transistors $134_3$ and $134_4$ is provided to remove the dependence of the drain potentials of the switching transistors 136 on the switching state of the segment (that is which of the output nodes has the current $I_{BLEED} + I$ and which of them has the current $I_{BLEED}$). Further details of the arrangement and operation of the cascode transistors $134_1$ to $134_4$ can be found in the applicant's co-pending patent application having publication number EP 2023489.

Operation of the Figure 12 embodiment is basically the same as that of the Figure 8 embodiment. However, each segment operates in a repeating sequence of four phases.

In a first phase, one of the transistors 136-1 and 136-2 is turned on and the other is turned off in dependence upon the data for the segment. All of the remaining switching transistors 136-3 to 136-8 are off. In a second phase, one of the transistors 136-3 and 136-4 is turned on and the other is turned off in dependence upon the data signal. The remaining transistors 136-1, 136-2 and 136-5 to 136-8 are all off. In a third phase, one of the switching transistors 136-5 and 136-6 is turned on and the other is turned off in dependence upon the data signal. The remaining transistors 136-1 to 136-4 and 136-7 and 136-8 are off. In a fourth phase, one of the transistors 136-7 and 136-8 is turned on and the other is turned off in dependence upon the data signal. The remaining transistors 136-1 to 136-6 are off.

The four-phase operation described above has the advantage that the same number of switching transistors change state from one phase to the next, irrespective of whether or not the data signal changes. For example, if in a first phase the switching transistor 136-1 is on and in the next phase the data remains the same, the transistor 136-1 is turned off and the transistor 136-3 is turned on. This kind of operation is not possible in the Figure 8 embodiment in which there is only one switching transistor 36-1 or 36-2 per output node. By arranging for the same number of switches to change state from one phase to the next, third-order distortion in the DAC is reduced.

Referring to Figure 9, it can be seen that the potential at the second node N2 in the first ladder arrangement $50_1$ will be different from the potential at the first node N1 of that ladder arrangement in operation of the circuitry. The same will be true for the nodes N1 and N2 in the second ladder arrangement $50_2$. Similarly, the potentials of the nodes N2 and N3 in each ladder arrangement will differ from one another in operation of the circuitry. This means that, although each of the shared load elements $132_1$ and $132_2$ should have the same impedance, the tap points TP1 and TP2 in segments 22-2 of the second segment group $SG_2$ will be different from the corresponding tap points in the first segments 22-1 in the first segment groups $SG_{11}$ to $SG_{1j}$. Similarly, the tap points in the segments 22-3 of the third segment group $SG_3$ will be different from the corresponding tap points in the second segments 22-2. However, this difference in the tap points does not affect the ability to match the relevant parameters, in particular the switching delays, of the segments. Among the different first segment groups, the tap points are all the same because each of them is coupled to the same node N1. The tap points are set out at the design stage. In the case of the second and third segment groups, the errors are less significant because, whereas MSB errors appear directly in the DAC output, the LSB errors are scaled. For example, in the case of 16 first segment groups each having four segments for the MSBs, the LSBs only contribute up to $1/_{64}^{th}$ of full scale in the DAC output.

Because of this, it is less critical to set the tap points correctly in the second and subsequent segments groups. For example, it would be possible to use the same tap points in the second and subsequent segment groups as are used in the first segment groups. Further, it would be possible to employ a single shared load element (for each of the two outputs) in the DAC (in addition to the load elements $132_1$ and $312_2$ in each segment) and connect the gates of the upper cascode transistors $134_1$ and $134_2$ of each segment instead to corresponding shared tap points in the shared load elements. Optionally, it would be possible instead to connect those gates to a constant DC voltage source. Because, as mentioned above, the LSBs are less significant than the MSBs, the tap point in such a single shared load element, or the DC voltage level of the DC voltage source, should preferably be optimised with respect to the MSBs. Further possibilities are set out in the applicant's co-pending patent application having publication number EP 2023489. Although the present invention has been described in relation to a segmented DAC, it will be appreciated that in other embodiments the invention can be applied in any kind of segmented mixed-signal circuitry. For example, the invention can be applied to digitally-programmable current generators and mixers

It will also be understood that although in the foregoing embodiments n-channel FET transistors have been used, embodiments of the present invention can also make use of p-channel FETs. In this case the currents flow out of the output terminals/nodes of the circuitry, rather than into them, and the segments contain current source circuits rather than current sink circuits.

Also, in place of FET transistors, bipolar transistors can be used, as can any other kind of three-terminal current device such as a valve. Effectively, any high-speed current switch can be employed in each segment in order to switch a current between two paths in dependence upon a control signal.

**Claims**

1. Segmented circuitry comprising:

    a plurality of mutually-similar and mutually-similarly-scaled segments (22), including at least three first segments (21-1) and at least three second segments (22-2), each said segment having signal changing means operable to change a magnitude of a controllable current signal of the segment in dependence upon a control signal, each said first segment being connected operatively to a first node (N1) of the circuitry such that its controllable current signal passes through the first node and each said second segment being connected operatively to a second node (N2) of the circuitry such that its controllable current signal passes through the second node; and
    impedance ladder means, including a first load impedance element ($Z_L$; $Z_{LG}$; 32) connected between said first node and a load line and a second load impedance element ($Z_L$; $Z_{LG}$; 32) connected between said second node and said load line and a divider impedance element ($Z_{DIV}$) connected between said first and second nodes, for producing a weighted combination of the controllable current signals of the plurality of segments, a contribution of the controllable current signal of each said second segment to said weighted combination being 1/k of a contribution of the controllable current signal of each said first segment based on the values of said impedance elements, where k is a scaling factor, and where the load line is a ground or another supply reference,
    wherein the control signals for the first segments are derived from first bits (B1) of a digital input signal of the circuitry, and the control signals for the second segments are derived from second bits (B2) of said digital input signal, each said second bit being less significant than each first bit.

2. Segmented circuitry as claimed in claim 1, wherein:

    the plurality of mutually-similar and mutually-similarly-scaled segments also includes a third segment (22-3), the third segment also having such signal changing means operable to change a magnitude of a controllable current signal of the segment in dependence upon a control signal, and the third segment being connected operatively to a third node (N3) of the circuitry such that its controllable current signal passes through the third node; and
    the impedance ladder means further includes a third load impedance element ($Z_L$; $Z_{LG}$; 32) connected between said third node and said load line and a further divider impedance element ($Z_{DIV}$) connected between said second and third nodes, such that a contribution of the controllable current signal of said third segment to said weighted combination is 1/k of said contribution of the controllable current signal of each said second segment.

3. Segmented circuitry as claimed in claim 2, wherein:

    said plurality of mutually-similar and mutually-similarly-scaled segments also includes one or more further segments, each said further segment having such signal changing means operable to change a magnitude of a controllable current signal of the segment in dependence upon a control signal and each said further segment being connected operatively to a corresponding further node of the circuitry such that its controllable current signal passes through that corresponding further node of the circuitry; and said impedance ladder means further includes a further load impedance element connected between each said further node and said load line and also includes a further divider impedance element connected between each said further node and the preceding node.

4. Segmented circuitry as claimed in claim 2 or 3, wherein at least one of the third and subsequent nodes, if any, has two or more such segments connected operatively to the node concerned.

5. Segmented circuitry as claimed in claim 4, wherein the segments are arranged in segment groups, each segment group comprising the same number of segments, the segments of each group being connected operatively to the same one of said nodes.

6. Segmented circuitry as claimed in claim 5, wherein the number of said segment groups for the first segments is greater than the number of segment groups for said second and any subsequent segments.

7. Segmented circuitry as claimed in any preceding claim, wherein an impedance of the or each said divider impedance element is $(k-1)^2/k$ times an impedance of the or each said load impedance element.

8. Segmented circuitry as claimed in any preceding claim, wherein a last one of said nodes of the circuitry is connected to said load line by a terminating impedance element ($Z_{TERM}$).

9. Segmented circuitry as claimed in claim 8, wherein an impedance of said terminating impedance element is k-1 times an impedance of the or each said load impedance element.

10. Segmented circuitry as claimed in any preceding claim, wherein each said divider impedance element comprises a resistance element (62) and a bridge capacitor (64) connected in parallel with the resistance element (62).

11. Segmented circuitry as claimed in claim 10, wherein a capacitance of said bridge capacitor is at least $k/(k-1)^2$ times a parasitic capacitance of a resistance element in each said load impedance element.

12. Segmented circuitry as claimed in claim 10 or 11, wherein a capacitance of said bridge capacitor is selected so as to compensate for losses at high frequency arising from capacitances of, or associated with, the segments.

13. Segmented circuitry as claimed in any preceding claim, wherein the or each said divider impedance element (62) and each said load impedance element (32) comprises a plurality of mutually-similar unit resistance elements (70).

14. Segmented circuitry as claimed in claim 13, wherein a number of said unit resistance elements (70) in the or each said divider impedance element is the same as a number of said unit resistance elements in each said load impedance element, the unit resistance elements of the or each said divider impedance element being interconnected differently from the unit resistance elements of each said load impedance element so that the or each said divider impedance element has a different impedance from each said load impedance element.

15. Segmented circuitry as claimed in any preceding claim, wherein each segment has first and second such controllable current signals and said signal changing means in each said segment are operable to change respective magnitudes of said first and second controllable current signals of the segment in dependence upon said control signal, and the circuitry has first and second sets of nodes, each said set having such first and subsequent nodes, and the circuitry also has first and second such impedance ladder means, said first impedance ladder means being operable to produce such a weighted combination of the first controllable current signals of the plurality of segments and said second impedance ladder means being operable to produce such a weighted combination of the second controllable current signals of the plurality of segments.

16. Segmented circuitry as claimed in any preceding claim, wherein each said segment comprises a current source or sink connected to a common node of the segment and at least one first switch connected between said common node and a first output node of the segment and at least one second switch connected between said common node and a second output node of the segment.

17. Segmented circuitry as claimed in claim 16, having two or more such first switches and two or more such second switches, and also having means for controlling the first and second switches such that at each switching event the same number of switches change state.

18. Segmented circuitry as claimed in claim 16 or 17, wherein each said segment further comprises means for reducing an output impedance at each said output node.

**19.** A digital-to-analogue converter or a segmented programmable current generator comprising segmented circuitry as claimed in any preceding claim, wherein the digital input signal is an input signal of the converter or generator.

**20.** An IC chip or chipset comprising circuitry, a digital-to-analogue converter or a segmented programmable current generator, as the case may be, according to any of the preceding claims.

**21.** An RF transmitter comprising circuitry, a digital-to-analogue converter, a segmented programmable current generator, or an IC chip or chipset, as the case may be, according to any of the preceding claims.

**Patentansprüche**

**1.** Segmentierte Schaltungsanordnung, aufweisend:

mehrere einander ähnliche und zueinander ähnlich skalierte Segmente (22), welche mindestens drei erste Segmente (21-1) und mindestens drei zweite Segmente (22-2) umfassen, wobei ein jeweiliges der Segmente Signaländerungsmittel aufweist, die zum Ändern einer Größe eines steuerbaren Stromsignals des Segments abhängig von einem Steuersignal betreibbar sind, wobei ein jeweiliges der ersten Segmente operativ mit einem ersten Knoten (N1) der Schaltungsanordnung derart verbunden ist, dass sein steuerbares Stromsignal den ersten Knoten durchläuft, und ein jeweiliges der zweiten Segmente operativ mit einem zweiten Knoten (N2) der Schaltungsanordnung derart verbunden ist, dass sein steuerbares Stromsignal den zweiten Knoten durchläuft; und Impedanzleiter-Mittel, welche ein erstes Lastimpedanzelement ($Z_L$; $Z_{LG}$; 32), das zwischen den ersten Knoten und eine Lastleitung geschaltet ist, ein zweites Lastimpedanzelement ($Z_L$; $Z_{LG}$; 32), das zwischen den zweiten Knoten und die Lastleitung geschaltet ist, und ein Teilerimpedanzelement ($Z_{DIV}$) aufweisen, das zwischen den ersten und den zweiten Knoten geschaltet ist, zum Erzeugen einer gewichteten Kombination der steuerbaren Stromsignale der mehreren Segmente, wobei ein Beitrag des steuerbaren Stromsignals eines jeweiligen der zweiten Segmente zu der gewichteten Kombination 1/k eines Beitrags des steuerbaren Stromsignals eines jeweiligen der ersten Segmente basierend auf den Werten der Impedanzelemente ist, wobei k ein Skalierfaktor ist, und wobei die Lastleitung Masse oder eine andere Versorgungsreferenz ist,

wobei die Steuersignale für die ersten Segmente von ersten Bits (B1) eines digitalen Eingangssignals der Schaltungsanordnung abgeleitet sind und die Steuersignale für die zweiten Segmente von zweiten Bits (B2) des digitalen Eingangssignals abgeleitet sind, wobei ein jeweiliges der zweiten Bits weniger signifikant ist als ein jeweiliges erstes Bit.

**2.** Segmentierte Schaltungsanordnung nach Anspruch 1, wobei:

die mehreren einander ähnlichen und zueinander ähnlich skalierten Segmente außerdem ein drittes Segment (22-3) umfassen, das dritte Segment ebenfalls solche Signaländerungsmittel aufweist, die zum Ändern einer Größe eines steuerbaren Stromsignals des Segments abhängig von einem Steuersignal betreibbar sind, und das dritte Segment operativ mit einem dritten Knoten (N3) der Schaltungsanordnung derart verbunden ist, dass sein steuerbares Stromsignal den dritten Knoten durchläuft; und die Impedanzleiter-Mittel ferner ein drittes Lastimpedanzelement ($Z_L$; $Z_{LG}$; 32), das zwischen den dritten Knoten und die Lastleitung geschaltet ist, und ein weiteres Teilerimpedanzelement ($Z_{DIV}$), das zwischen den zweiten und den dritten Knoten geschaltet ist, aufweisen, derart, dass ein Beitrag des steuerbaren Stromsignals des dritten Segments zu der gewichteten Kombination 1/k des Beitrags des steuerbaren Stromsignals eines jeweiligen der zweiten Segmente ist.

**3.** Segmentierte Schaltungsanordnung nach Anspruch 2, wobei:

die mehreren einander ähnlichen und zueinander ähnlich skalierten Segmente außerdem ein oder mehrere weitere Segmente umfassen, ein jeweiliges der weiteren Segmente solche Signaländerungsmittel zum Ändern einer Größe eines steuerbaren Stromsignals des Segments abhängig von einem Steuersignal aufweist und ein jeweiliges der weiteren Segmente operativ mit einem entsprechenden weiteren Knoten der Schaltungsanordnung derart verbunden ist, dass sein steuerbares Stromsignal jenen entsprechenden weiteren Knoten der Schaltungsanordnung durchläuft; und die Impedanzleiter-Mittel ferner, zwischen einen jeweiligen der weiteren Knoten und der Lastleitung geschaltet, ein weiteres Lastimpedanzelement aufweisen und außerdem, zwischen einen jeweiligen der weiteren Knoten und den vorangehenden Knoten geschaltet, ein weiteres Teilerimpedanzelement aufweisen.

**4.** Segmentierte Schaltungsanordnung nach Anspruch 2 oder 3, wobei der dritte Knoten und/oder, sofern vorhanden, mindestens einer der nachfolgenden Knoten zwei oder mehr solche mit dem betreffenden Knoten verbundene Segmente aufweist.

**5.** Segmentierte Schaltungsanordnung nach Anspruch 4, wobei die Segmente in Segmentgruppen angeordnet sind, jede Segmentgruppe die gleiche Anzahl von Segmenten umfasst und die Segmente jeder Gruppe operativ mit demselben einen der Knoten verbunden sind.

**6.** Segmentierte Schaltungsanordnung nach Anspruch 5, wobei die Anzahl der Segmentgruppen für die ersten Segmente größer ist als die Anzahl der Segmentgruppen für die zweiten und alle etwaig vorhandenen nachfolgenden Segmente.

**7.** Segmentierte Schaltungsanordnung nach einem der vorangehenden Ansprüche, wobei eine Impedanz des Teilerimpedanzelements bzw. eines jeweiligen der Teilerimpedanzelemente das $(k-1)^2/k$-fache einer Impedanz des Lastimpedanzelements bzw. eines jeweiligen der Lastimpedanzelemente beträgt.

**8.** Segmentierte Schaltungsanordnung nach einem der vorangehenden Ansprüche, wobei ein letzter einer der Knoten der Schaltungsanordnung über ein Endimpedanzelement ($Z_{TERM}$) mit der Lastleitung verbunden ist.

**9.** Segmentierte Schaltungsanordnung nach Anspruch 8, wobei eine Impedanz des Endimpedanzelements das $(k-1)$-fache einer Impedanz des Lastimpedanzelements bzw. eines jeweiligen der Lastimpedanzelemente beträgt.

**10.** Segmentierte Schaltungsanordnung nach einem der vorangehenden Ansprüche, wobei ein jeweiliges der Teilerimpedanzelemente ein Widerstandselement (62) und einen Brückenkondensator (64) aufweist, der parallel zu dem Widerstandselement (62) geschaltet ist.

**11.** Segmentierte Schaltungsanordnung nach Anspruch 10, wobei eine Kapazität des Brückenkondensators mindestens das $k/(k-1)^2$-fache einer parasitären Kapazität eines Widerstandselements in einem jeweiligen der Lastimpedanzelemente beträgt.

**12.** Segmentierte Schaltungsanordnung nach Anspruch 10 oder 11, wobei eine Kapazität des Brückenkondensators derart gewählt ist, dass sie Verluste bei hohen Frequenzen kompensiert, die sich aufgrund von Kapazitäten der Segmente oder mit den Segmenten assoziierten Kapazitäten ergeben.

**13.** Segmentierte Schaltungsanordnung nach einem der vorangehenden Ansprüche, wobei das oder Teilerimpedanzelement (62), bzw. ein jeweiliges der Teilerimpedanzelemente, und ein jeweiliges der Lastimpedanzelemente (32) mehrere einander ähnliche Einheitswiderstandselemente (70) aufweisen.

**14.** Segmentierte Schaltungsanordnung nach Anspruch 13, wobei eine Anzahl der Einheitswiderstandselemente (70) in dem Teilerimpedanzelement bzw. in einem jeweiligen der Teilerimpedanzelemente gleich einer Anzahl der Einheitswiderstandselemente in einem jeweiligen der Lastimpedanzelemente ist, wobei sich die Verschaltung der Einheitswiderstandselemente des Teilerimpedanzelements bzw. eines jeweiligen der Teilerimpedanzelemente von der Verschaltung der Einheitswiderstandselemente aller Lastimpedanzelemente unterscheidet, sodass das Teilerimpedanzelement bzw. ein jeweiliges der Teilerimpedanzelemente eine andere Impedanz aufweist als ein jeweiliges der Lastimpedanzelemente.

**15.** Segmentierte Schaltungsanordnung nach einem der vorangehenden Ansprüche, wobei jedes Segment ein erstes und ein zweites solches steuerbares Stromsignal aufweist und die Signaländerungsmittel in einem jeweiligen der Segmente dazu betreibbar sind, die Größe des ersten und zweiten steuerbaren Stromsignals des Segments abhängig von dem Steuersignal zu ändern, und die Schaltungsanordnung einen ersten und einen zweiten Satz Knoten aufweist, wobei ein jeweiliger der Sätze einen solchen ersten Knoten und solche nachfolgende Knoten aufweist, und die Schaltungsanordnung außerdem erste und zweite solche Impedanzleiter-Mittel aufweist, wobei die ersten Impedanzleiter-Mittel dazu betreibbar sind, eine solche gewichtete Kombination aus den ersten steuerbaren Stromsignalen der mehreren Segmente zu erzeugen, und die zweiten Impedanzleiter-Mittel dazu betreibbar sind, eine solche gewichtete Kombination aus den zweiten steuerbaren Stromsignalen der mehreren Segmente zu erzeugen.

**16.** Segmentierte Schaltungsanordnung nach einem der vorangehenden Ansprüche, wobei ein jeweiliges der Segmente eine Stromquelle oder -senke, die mit einem gemeinsamen Knoten des Segments verbunden ist, mindestens einen ersten Schalter, der zwischen den gemeinsamen Knoten und einen ersten Ausgangsknoten des Segments geschaltet ist, und mindestens einen zweiten Schalter aufweist, der zwischen den gemeinsamen Knoten und einen zweiten Ausgangsknoten des Segments geschaltet ist.

**17.** Segmentierte Schaltungsanordnung nach Anspruch 16 mit zwei oder mehr solchen ersten Schaltern und zwei oder mehr solchen zweiten Schaltern sowie mit Mitteln zum Steuern der ersten und zweiten Schalter, sodass bei jedem Schaltvorgang die gleiche Anzahl von Schaltern den Zustand ändert.

18. Segmentierte Schaltungsanordnung nach Anspruch 16 oder 17, wobei ein jeweiliges der Segmente ferner Mittel zum Reduzieren einer Ausgangsimpedanz an einem jeweiligen der Ausgangsknoten aufweist.

19. Digital-analog-Wandler oder segmentierter programmierbarer Stromgenerator mit einer segmentierten Schaltungsanordnung nach einem der vorangehenden Ansprüche, wobei das digitale Eingangssignal ein Eingangssignal des Wandlers oder Generators ist.

20. IC-Chip oder -Chipsatz mit einem Digital-analog-Wandler oder einem segmentierten programmierbaren Stromgenerator nach einem der vorangehenden Ansprüche.

21. HF-Sender mit einer Schaltungsanordnung, einem Digital-zu-analog-Wandler, einem segmentierten programmierbaren Stromgenerator oder einem IC-Chip oder -Chipsatz nach einem der vorangehenden Ansprüche.

**Revendications**

1. Montage de circuits segmentés comprenant :

   une pluralité de segments mutuellement similaires et de segments mis à l'échelle de manière mutuellement similaire (22), incluant au moins trois premiers segments (21-1) et au moins trois seconds segments (22-2), chaque dit segment présentant un moyen de modification de signal exploitable de manière à modifier l'amplitude d'un signal de courant pouvant être commandé du segment, en fonction d'un signal de commande, chaque dit premier segment étant connecté fonctionnellement à un premier noeud (N1) du montage de circuit, de sorte que son signal de courant pouvant être commandé passe à travers le premier noeud, et chaque dit deuxième segment étant connecté fonctionnellement à un deuxième noeud (N2) du montage de circuit, de sorte que son signal de courant pouvant être commandé passe à travers le deuxième noeud ; et
   un moyen d'échelle d'impédance, incluant un premier élément d'impédance de charge ($Z_L$ ; $Z_{LG}$ ; 32) connecté entre ledit premier noeud et une ligne de charge, et un deuxième élément d'impédance de charge ($Z_L$ ; $Z_{LG}$ ; 32) connecté entre ledit deuxième noeud et ladite ligne de charge, et un élément d'impédance de répartiteur ($Z_{DIV}$) connecté entre lesdits premier et deuxième noeuds, en vue de produire une combinaison pondérée des signaux de courant pouvant être commandés de la pluralité de segments, dans lequel une contribution du signal de courant pouvant être commandé de chaque dit deuxième segment à ladite combinaison pondérée représente 1/k d'une contribution du signal de courant pouvant être commandé de chaque dit premier segment sur la base des valeurs desdits éléments d'impédance, où « k » est un facteur d'échelle, et où la ligne de charge est une masse ou une autre référence d'alimentation ;
dans lequel les signaux de commande pour les premiers segments sont dérivés de premiers bits (B1) d'un signal d'entrée numérique du montage de circuits, et les signaux de commande pour les seconds segments sont dérivés de seconds bits (B2) dudit signal d'entrée numérique, chaque dit second bit étant d'un poids moins fort que chaque premier bit.

2. Montage de circuits segmentés selon la revendication 1, dans lequel :

   la pluralité de segments mutuellement similaires et de segments mis à l'échelle de manière mutuellement similaire inclut également un troisième segment (22-3), le troisième segment présentant également un tel moyen de modification de signal exploitable de manière à modifier une amplitude d'un signal de courant pouvant être commandé du segment en fonction d'un signal de commande, et le troisième segment étant connecté fonctionnellement à un troisième noeud (N3) du montage de circuits, de sorte que son signal de courant pouvant être commandé passe par le troisième noeud ; et
   le moyen d'échelle d'impédance inclut en outre un troisième élément d'impédance de charge ($Z_L$ ; $Z_{LG}$ ; 32) connecté entre ledit troisième noeud et ladite ligne de charge, et un élément d'impédance de répartiteur ($Z_{DIV}$) supplémentaire connecté entre lesdits deuxième et troisième noeuds, de sorte qu'une contribution du signal de courant pouvant être commandé dudit troisième segment à ladite combinaison pondérée représente 1/k de ladite contribution du signal de courant pouvant être commandé de chaque dit deuxième segment.

3. Montage de circuits segmentés selon la revendication 2, dans lequel :

   ladite pluralité de segments mutuellement similaires et de segments mis à l'échelle de manière mutuellement similaire inclut également un ou plusieurs segments supplémentaires, chaque dit segment supplémentaire présentant un tel moyen de modification de signal exploitable de manière à modifier une amplitude d'un signal de courant pouvant être commandé du segment en fonction d'un signal de commande, et chaque dit segment supplémentaire étant connecté fonctionnellement à un noeud supplémentaire correspondant du montage de circuits, de sorte que son signal de courant pouvant être commandé passe à travers ce noeud supplémentaire correspondant du montage de circuits ; et ledit moyen d'échelle d'impédance inclut en outre un élément d'impédance de charge supplémentaire connecté entre chaque dit noeud supplémentaire et ladite ligne de charge, et inclut également un élément d'impédance de répartiteur supplémentaire connecté entre chaque dit noeud supplémentaire et le noeud précédent.

4. Montage de circuits segmentés selon la revendication 2 ou 3, dans lequel au moins l'un des troisièmes noeuds et des noeuds subséquents, le cas échéant, présente deux de ces segments ou plus connectés fonctionnellement au noeud concerné.

5. Montage de circuits segmentés selon la revendication 4, dans lequel les segments sont agencés en groupes de segments, chaque groupe de segments comprenant le même nombre de segments, les segments de chaque groupe étant connectés fonctionnellement au même noeud desdits noeuds.

6. Montage de circuits segmentés selon la revendication 5, dans lequel le nombre desdits groupes de segments pour les premiers segments est supérieur au nombre de groupes de segments pour ledit deuxième segment et tout segment subséquent.

7. Montage de circuits segmentés selon l'une quelconque des revendications précédentes, dans lequel une impédance du ou de chaque élément d'impédance de répartiteur est égale à $(k-1)^2/k$ fois une impédance du ou de chaque élément d'impédance de charge.

8. Montage de circuits segmentés selon l'une quelconque des revendications précédentes, dans lequel un dernier desdits noeuds du montage de circuits est connecté à ladite ligne de charge par un élément d'impédance de terminaison ($Z_{TERM}$).

9. Montage de circuits segmentés selon la revendication 8, dans lequel une impédance dudit élément d'impédance de terminaison est égale à $k-1$ fois une impédance dudit ou de chaque dit élément d'impédance de charge.

10. Montage de circuits segmentés selon l'une quelconque des revendications précédentes, dans lequel chaque dit élément d'impédance de répartiteur comprend un élément de résistance (62), et un condensateur en pont (64) connecté en parallèle à l'élément de résistance (62).

11. Montage de circuits segmentés selon la revendication 10, dans lequel une capacité dudit condensateur en pont représente au moins $k/(k-1)^2$ fois une capacité parasite d'un élément de résistance dans chaque dit élément d'impédance de charge.

12. Montage de circuits segmentés selon la revendication 10 ou 11, dans lequel une capacité dudit condensateur en pont est sélectionnée de manière à compenser des pertes à haute fréquence résultant de capacités des segments ou de capacités associées aux segments.

13. Montage de circuits segmentés selon l'une quelconque des revendications précédentes, dans lequel ledit ou chaque dit élément d'impédance de répartiteur (62) et chaque dit élément d'impédance de charge (32) comprennent une pluralité d'éléments de résistance unitaire mutuellement similaires (70).

14. Montage de circuits segmentés selon la revendication 13, dans lequel un nombre desdits éléments de résistance unitaire (70) dans ledit ou chaque dit élément d'impédance de répartiteur est le même qu'un nombre desdits éléments de résistance unitaire dans chaque dit élément d'impédance de charge, les éléments de résistance unitaire dudit ou de chaque dit élément d'impédance de répartiteur étant interconnectés différemment des éléments de résistance unitaire de chaque dit élément d'impédance de charge, de sorte que ledit ou chaque dit élément d'impédance de répartiteur présente une impédance différente de chaque dit élément d'impédance de charge.

15. Montage de circuits segmentés selon l'une quelconque des revendications précédentes, dans lequel chaque segment présente des premier et second signaux de courant pouvant être commandés et ledit moyen de modification de signal dans chaque dit segment est exploitable de manière à modifier des amplitudes respectives desdits premier et second signaux de courant pouvant être commandés du segment, en fonction dudit signal de commande, et le montage de circuits présente des premier et second ensembles de noeuds, chaque dit ensemble présentant de tels premiers noeuds et noeuds subséquents, et le montage de circuits présente également des premier et second moyens d'échelle d'impédance, ledit premier moyen d'échelle d'impédance étant exploitable de manière à produire une telle combinaison pondérée des premiers signaux de courant pouvant être commandés de la pluralité de segments, et ledit second moyen d'échelle d'impédance étant exploitable de manière à produire une telle combinaison pondérée des seconds signaux de courant pouvant être commandés de la pluralité de segments.

16. Montage de circuits segmentés selon l'une quelconque des revendications précédentes, dans lequel chaque dit segment comprend une source ou un puits de courant connecté à un noeud commun du segment, et au moins un premier commutateur connecté entre ledit noeud commun et un premier noeud de sortie du segment, et au moins un second commutateur connecté entre ledit noeud commun et un deuxième noeud de sortie du segment.

17. Montage de circuits segmentés selon la revendication 16, présentant deux tels premiers commutateurs ou plus, et deux tels seconds commutateurs ou plus, et présentant également des moyens pour commander les premiers et seconds commutateurs de sorte qu'à chaque événement de commutation, le même nombre de commutateurs change d'état.

18. Montage de circuits segmentés selon la revendication 16 ou 17, dans lequel chaque dit segment comprend en outre un moyen pour réduire une impédance de sortie au niveau de chaque dit noeud de sortie.

19. Convertisseur numérique-analogique ou générateur de courant programmable segmenté comprenant le montage de circuits segmentés selon l'une quelconque des revendications précédentes, dans lequel le signal d'entrée numérique est un signal d'entrée du convertisseur ou du générateur.

20. Jeu de puces ou puce IC comprenant un montage de circuits, un convertisseur numérique-analogique ou un générateur de courant programmable segmenté, selon le cas, selon l'une quelconque des revendications précédentes.

21. Émetteur RF comprenant un montage de circuits, un convertisseur numérique-analogique, un générateur de courant programmable segmenté, ou un jeu de puces ou une puce IC, selon le cas, selon l'une quelconque des revendications précédentes.

FIG. 1

FIG. 2

FIG. 3

FIG. 4

FIG. 5

EP 2 019 490 B1

FIG. 6

FIG. 7

FIG. 8

FIG. 9

EP 2 019 490 B1

60  64

62

FIG. 10

32

70

FIG. 11(A)

62

FIG. 11(B)

FIG. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5703586 A
- US 20060092065 A1
- US 7173552 B
- US 5612696 A
- EP 2023489 A